# EUROPEAN PATENT APPLICATION

(11) **EP 4 389 497 A1**
(43) Date of publication of application: **26.06.2024**
(21) Application number: 22214604.5
(22) Date of filing: 19.12.2022
(51) Int. Cl.: B60L 3/12, B60L 58/16, B60L 15/20, B60W 30/20, H01M 50/242, B60K 1/04, B60L 50/60, B60R 16/04, G01R 31/392

(54) **USAGE OF VIBRATION DATA AND SOH FEEDBACK FOR CONTROLLING BATTERY PACK VIBRATION**

(71) Applicant: VOLVO TRUCK CORPORATION, 405 08 Göteborg (SE)
(72) Inventor: RAY, Dripta, 412 76 GÖTEBORG (SE); ALTAF, Faisal, 421 43 VÄSTRA FRÖLUNDA (SE)
(74) Representative: Kransell & Wennborg KB

(57) **Abstract**

The invention relates to a computer implemented-method for improving a lifetime of an electrical energy storage system (2) adapted for providing propulsion power for a vehicle (1), the method comprising: estimating (S102) a present state of health of the electrical energy storage system; determining (S104) vibration data (5) including mechanical vibration magnitude and vibration frequency spectrum of the electrical energy storage system; determining (S106) a degree of impact (S) of the vibrations of the electrical energy storage system on the state of health of the electrical energy storage system by processing the determined vibration magnitude and vibration frequency spectrum in a vibration-SOH model (10) adapted to infer a relationship between vibration magnitude and vibration frequency spectrum, and state of health, and adapting (S110) at least one vehicle control parameter (P) to vary at least one of the vibration magnitude and the vibration frequency to reduce the determining a degree of impact of the vibrations of the electrical energy storage system.

## Description

### TECHNICAL FIELD

The present disclosure relates to a method for improving a lifetime of an electrical energy storage system. The present disclosure also relates to a system, a control unit, and computer program. Although the method and system will be described in relation to a vehicle in the form of a truck, the method and system can also be efficiently incorporated in other vehicle types such as buses, light-weight trucks, passenger cars, construction equipment, marine vessels, and industrial equipment, as long as they are at least partly electrically propelled.

### BACKGROUND

The performance of traction batteries in electric vehicles degrades over time due to various internal and external stress factors. For example, temperature, SoC windows, power levels, energy-throughput, have significant impact on ageing rate.

Traction batteries are relatively expensive, and it is therefore desirable to extend their lifetime as much as possible. In addition, replacement of traction batteries leads to unnecessary downtime of the electric vehicle. Further, the environmental impact of traction battery production should be minimized.

Accordingly, the present disclosure provides for improvements with regards to extending the lifetime of traction batteries for electric vehicles.

### SUMMARY

The present disclosure aims to provide an improved method and system for improving the lifetime of an electrical energy storage system of a vehicle.

According to the first aspect, there is provided a method for improving a lifetime of an electrical energy storage system adapted for providing propulsion power for a vehicle, the method comprising: estimating a present state of health of the electrical energy storage system; determining vibration data including mechanical vibration magnitude and vibration frequency spectrum of the electrical energy storage system; determining a degree of impact of the vibrations of the electrical energy storage system on the state of health of the electrical energy storage system by processing the determined vibration magnitude and vibration frequency spectrum in a vibration-SOH model adapted to infer a relationship between vibration magnitude and vibration frequency spectrum, and state of health, and adapting at least one vehicle control parameter to vary at least one of the vibration magnitude and the vibration frequency to reduce the degree of impact of the vibrations of the electrical energy storage system.

The vibration magnitude is indicative of the span, in unit length, of the vibration. Equally, the vibration magnitude is the total power of the vibration. The vibration spectrum is the power per unit frequency. That is, the power of the vibration as a function of frequency of the vibrations.

The vibration-SOH model is a model that is constructed based on cause-effect evaluations of the vibrations and how they affect the SOH. Thus, depending on the measured vibration magnitude and spectrum, the vibration-SOH model can quantify the impact that the vibrations have on the state of health of the electrical energy storage system. The vibration-SOH model is constructed with measured data to build a correlation-based model, that is, an empirical relationship between vibration data collected over time, correlated with the effect the collected vibration data had on the SOH.

State of health, SOH, may be defined as the loss in capacity relative to a capacity at the beginning of life of the battery, or the internal resistance increase of the battery relative the internal resistance at the beginning of life of the battery. Further, state of health may equally be defined of loss in range, loss in peak acceleration capability, efficiency loss, loss in power-ability etc.

State of health parameters that may be measured for determining a state of health may include at least a state of capacity, a state of resistance, and/or state of power of the battery. These state of health parameters are well established and advantageously relatively straight-forward to measure and are typically available from automotive battery management systems (BMS).

State of charge, SOC, which is mentioned herein is the present level of charge in the electrical energy storage compared to its full capacity and may be given as a percentage value.

The propulsion electrical energy storage should be interpreted as providing propulsion energy to the vehicle. Thus, the vehicle may be an electrical, hybrid, or plug-in hybrid vehicle comprising an electrical engine, wherein the electrical energy storage provides power to the electrical engine for providing propulsion for the electrical, hybrid, or plug-in hybrid vehicle. The electrical energy storage may be Li-ion electrical energy storage comprising multiple cells arranged in series and in parallel as is known in the art.

In one example, adapting the at least one vehicle control parameter may include employing a vibration model including at least one relationship between the at least one vehicle control parameter and the respective effect on the vibration magnitude and the vibration frequency of the electrical energy storage system. In other words, a second model may be used which provides, as an output, with one or more control parameters to adjust and the amount of adjustment that should be made to reduce the determined degree of impact of the vibrations. Such vibration model may also be constructed as an empirical model from measured vibration data collected when a known vehicle control parameter is adjusted, and by correlating that vibration data with the effect on the SOH. Adjusting the vehicle control parameter may aim to maintain a present SOH of the electrical energy storage device.

In one example, the at least one vehicle control parameter may include a speed profile, an acceleration profile, a gear-shifting strategy, a braking strategy, and steering control, and a dampening mechanism, of the vehicle.

In one example, the dampening mechanism may be a controllable local dampening mechanism for the electrical energy storage system. The local dampening may be an active dampening mechanism or adaptive dampening mechanism that is controllable by a processor device.

A local dampening mechanism may be combination of spring and shock-absorbing device whose stiffness and dampness can be controlled and that is installed between electrical energy storage devices and chassis i.e., the electrical energy storage device is not directly connected with chassis but through controllable damping mechanism. The damping mechanism thus isolates electrical energy storage device to some extent from vehicle structure and filter out vibrations originating from chassis.

It is also envisaged that vibrations can be dampened through dampers installed on vehicle level e.g., between vehicle axle and chassis. Those dampers in some cases can also be actively controlled i.e., stiffness and dampness coefficients can be adapted in real-time by a processor device.

In one example, adapting may comprise adapting a combination of at least two vehicle control parameters. In other words, two different mechanisms may be controlled in conjunction to reduce the degree of impact of the vibrations on the SOH of the electrical energy storage system.

In one example, one of the at least two vehicle control parameters may be a local dampening mechanism for the electrical energy storage system.

In one example, the vehicle control parameters may be adapted in such a way that the vehicle can reach an intended destination subject to travelling constraints. In other words, some vibrations may still be allowed, but the effect of the vibrations should be reduced or altered as much as possible to reduce ageing of the electrical energy storage capabilities, while still fulfilling the constraints. Such constraints may be to arrive in-time, to ensure a predetermined driving experience, the driveability, passenger comfort, road speed limits, to mention a few examples.

It is envisaged that determining the vibration data can be performed by a measurement or by an estimation from secondary data, or a combination of a measurement and an estimation. In one example, the vibration data may be measured using a vibration sensor arranged on or near the electrical energy storage system or on an electrical energy storage cell, and the mechanical vibration magnitude and vibration frequency spectrum are determined from analysing the vibration data. Providing a separate and dedicated sensor for measuring the vibration advantageously allows for acquired accurate and specific data for the vibrations near or even directly on the electrical energy storage pack.

In one example, an outcome of the adaption of at least one vehicle control parameter on the state of health of the electrical energy storage system may be fed back to update the vibration model that provides the adjusted vehicle control parameter. Thus, the vibration model may advantageously be improved on-line to increase the accuracy of its estimations.

In one example, the method steps are performed while the vehicle is travelling.

In one example, the method steps may be performed in a cruise control mode or self-driving mode of the vehicle.

An electrical energy storage system may herein be considered a battery.

The methods described herein are preferably computer-implemented.

According to a second aspect there is provided a computer program product comprising program code for performing, when executed by a processor device, the method of the first aspect when said program is run on a computer.

According to a third aspect there is provided a non-transitory computer-readable storage medium comprising instructions, which when executed by the processor device, cause the processor device to perform the method of the first aspect.

According to a fourth aspect there is provided a control unit for improving a lifetime of an electrical energy storage system adapted for providing propulsion power for a vehicle, the control unit is configured to perform the steps of the method according to the first aspect.

According to a fifth aspect there is provided a system for improving a lifetime of an electrical energy storage system adapted for providing propulsion power for a vehicle, the system comprising: a vibration sensor on or near the electrical energy storage system, the vibration sensor is configured to acquire vibration data indicative of a vibration magnitude and vibration frequency spectrum of the electrical energy storage system; and a control unit according to the fourth aspect.

Effects and features of the second, third, fourth, and fifth aspects are largely analogous to those described above in relation to the first aspect.

Further features of, and advantages will become apparent when studying the appended claims and the following description. The skilled person will realize that different features may be combined to create embodiments other than those described in the following, without departing from the scope of the present disclosure.

### BRIEF DESCRIPTION OF THE DRAWINGS

With reference to the appended drawings, below follows a more detailed description of embodiments of the invention cited as examples.

In the drawings:
Fig. 1 is a vehicle in the form of an electrical truck according to examples of the disclosure;
Fig. 2 is a flow-chart of method steps according to examples of the disclosure;
Fig. 3 is a block diagram of a system according to examples of the disclosure;
Fig. 4 is a functional block diagram of examples of the disclosure;
Fig. 5 is a block diagram of system according to examples of the disclosure;
Fig. 6 is a flow-chart of method steps according to examples of the disclosure; and
Fig. 7 is a schematic diagram of an exemplary computer system for implementing examples disclosed herein, according to one example.

### DETAILED DESCRIPTION OF EXAMPLE EMBODIMENTS OF THE INVENTION

The present invention will now be described more fully hereinafter with reference to the accompanying drawings, in which exemplary embodiments of the invention are shown. The invention may, however, be embodied in many different forms and should not be construed as limited to the embodiments set forth herein; rather, these embodiments are provided for thoroughness and completeness. The skilled person will recognize that many changes and modifications may be made within the scope of the appended claims.

Like reference character refer to like elements throughout the description.

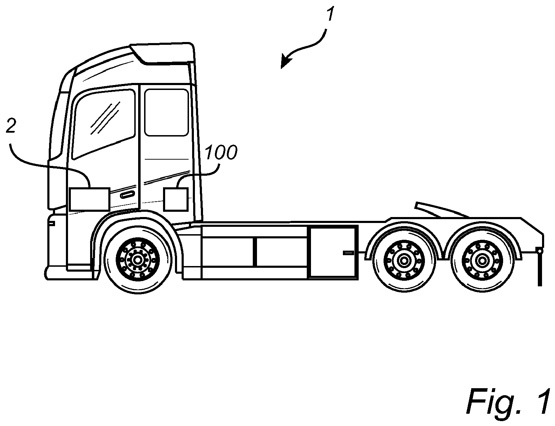

Fig. 1 illustrates a vehicle in the form of an electrical truck 1 comprising a propulsion electrical energy storage system 2 generally comprising a plurality of series and parallel connected electrical energy storage cells. The propulsion electrical energy storage 2 is arranged to provide power to an electrical engine (not shown) arranged for providing propulsion for the electrical truck 1. The electrical truck 1 further comprises a system 100 system for improving a lifetime of the electrical energy storage system 2. Generally, the vehicle comprises an electrical energy storage managing system which is configured to monitor electrical energy storage cell characteristics such as state of charge (SOC), state of health (SOH), state of power (SOP), state of energy (SOE), state of capacity (SOQ), etc., electrical energy storage voltage, state of resistance (SOR) i.e., internal impedance, and optionally temperature of the electrical energy storage cells. The propulsion electrical energy storage 2 may be a Li-ion electrical energy storage comprising multiple cells electrically connected in series and in parallel.

Although the vehicle in fig. 1 is depicted as a heavy-duty truck, embodiments of the present disclosure may as well be implemented in other types of vehicles, such as in busses, light-weight trucks, passenger cars, construction equipment, industrial applications, and marine applications including e.g. vessels or ships.

Many factors that affect aging of electrical energy storage systems are known. The inventors realized that vibrations affect aging of electrical energy storage system and to alter or counteract the vibrations to reduce the effect on aging of the electrical energy storage system. For this, on-board assessment of vibrations of electrical energy storage system with respect to aging is realized by examples discussed herein.

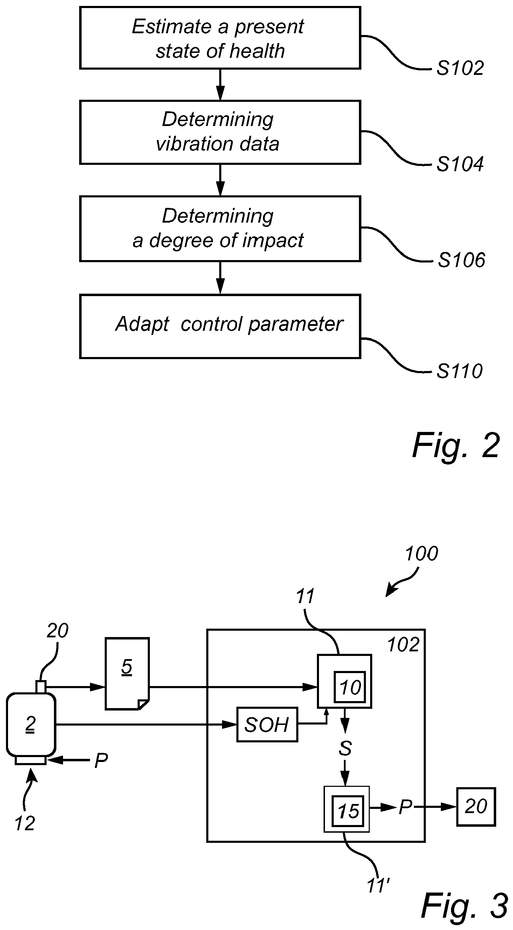

Fig. 2 is a flow-chart of method steps of examples described herein and fig. 3 is a block diagram of a system 100.

In step S102 a present state of health, SOH, of the electrical energy storage system is estimated by a control unit 102. The SOH is determined from known measures but generally relates to loss in capacity relative to a capacity at the beginning of life of the battery, or the internal resistance increase of the battery relative the internal resistance at the beginning of life of the battery. Further, SOH may equally be defined of loss in range, loss in peak acceleration capability, efficiency loss, loss in power-ability etc. SOH is derived or calculated from current, voltage, and/or temperature measurements of the cells or packs of the electrical energy storage system. The estimated SOH is used as input to a vibration-SOH model 10 accessible by the control unit 102 in a memory 11.

In step S104, vibration data 5 including mechanical vibration magnitude and vibration frequency spectrum of the electrical energy storage system 2 is determined by the control unit 102. The control unit 102 analyses the vibration data 5 to extract the spectrum and the vibration magnitude using suitable tools, such as Fourier analysis or other spectrum analysis tools. The vibration data 5 are preferably measured using a vibration sensor 20 arranged on or near the electrical energy storage system 2 or on an electrical energy storage cell. The mechanical vibration magnitude and vibration frequency spectrum are determined by the control unit 102 from analysing the vibration data 5.

In step S106, a degree of impact S of the vibrations of the electrical energy storage system 2 on the SOH of the electrical energy storage system 2 is determined by the control unit 102. For this, the control unit 102 processes the determined vibration magnitude and vibration frequency spectrum in a vibration-SOH model 10 adapted to infer a relationship between vibration magnitude and vibration frequency spectrum, and SOH.

The vibration-SOH model 10 is constructed from performing correlation between collected vibration data and the observed effect on the SOH to provide a cause-effect relationship. Preferably, the input vibration data includes full vibration power spectrum, i.e., vibration power magnitude at various frequencies. Further, other stress factors on SoH are decoupled and filtered before correlating SoH with vibration data otherwise to avoid associating all the ageing, that is, a reduction in SOH, with only vibrations.

When using the vibration-SOH model 10, the input vibration data 5 and the present SOH are correlated with the corresponding states in the vibration-SOH model 10. The output from the correlation provides basis for quantifying the impact of the vibration on the SOH.

In step S110, at least one vehicle control parameter P is adapted by the control unit 102 to vary at least one of the vibration magnitude and the vibration frequency of the electrical energy storage system 2 to reduce the determined degree of impact of the vibrations of the electrical energy storage system.

The vehicle control parameter may refer to many different ways of causing a counter vibration to reduce effect on the SOH caused by external vibrations. For example, a speed profile of the vehicle may be adapted to reduce vibrations. Adapting the speed profile is primarily used in a cruise control mode or self-driving mode of the vehicle and related to the absolute speed for individual stretches of an entire route, the average speed along the route, or specific combinations of speeds for stretches of the route. Similarly, an acceleration profile may be employed in a cruise control mode or self-driving mode of the vehicle. Other examples include a gear-shifting strategy, a braking strategy, steering control, and a dampening mechanism, of the vehicle.

A gear shifting strategy relates to which gears to use for the transmission of the vehicle along the route to ensure reduced vibrations. Braking strategy includes how aggressively to use the brakes of the vehicle, and to plan each braking operation to reduce vibrations. Steering control relates to turning radius and speed through turns. Dampening mechanism may be a local dampening at the electrical energy storage 2, or a more global dampening mechanism of the vehicle chassis. For example, the dampening mechanism may be a controllable local, active dampening mechanism 12, for the electrical energy storage system. The dampening mechanism 12 is controllable by the control unit 102 through suitable control messages.

A vehicle component 20 is controlled by the control unit by a control message transmitted from the control unit 102 to the vehicle component 20. The vehicle component 20 may be drive control system such as a cruise control system.

In examples, adapting the at least one vehicle control parameter includes employing a vibration model 15 including at least one relationship between the at least one vehicle control parameter and the respective effect on the vibration magnitude and the vibration frequency of the electrical energy storage system 2. The model 15 takes as input the degree of impact, S, as input. Evaluates the degree of impact, S, along with prestored relationships between given degree of impacts, S(1-n), and available vehicle control parameters. As an output the specific vehicle control parameter, P, or sets of vehicle control parameters, P(1-n) are provided, and to what extent they should be adapted. For example, a combination of at least two vehicle control parameters may be adapted, where one of the at least two vehicle control parameters is the local dampening mechanism 12 for the electrical energy storage system. The vibration model 15 may be stored on the memory 11 or on a separate memory 11'.

The adaption of the vehicle control parameters may be subject to constraints. For example, the vehicle should be allowed to arrive at the destination in a reasonable time which often means that some degree of vibrations is acceptable. Further constraints may be to arrive in-time according to a set time, ensure a predetermined driving experience, the driveability of the vehicle, passenger comfort, road speed limits, to mention a few examples.

In one advantageous example, the vibration model 15 is continuously updated. For this, a variation in vibration spectrum, i.e., power magnitude and frequency, is associated or correlated with the adaption, ΔP, in vehicle control parameter P that caused the variation in vibration spectrum. The variation and cause may be fed back to the model 15 to improve its performance. Thus, the vibration model is continually updated using data-driven methods to learn which part of vibration spectrum is sensitive to which vehicle control parameter. Finding this sensitivity further improves adapting the vehicle control parameter to mitigate vibrations even further.

In a similar way, the vibration-SOH model 10 may be improved by correlating the variation in SOH to the variation in vibration magnitude and spectrum between consecutively acquired vibration data.

The methods disclosed herein are suitably performed while the vehicle is travelling. Furthermore, the method steps are preferably performed in a cruise control mode or self-driving mode of the vehicle.

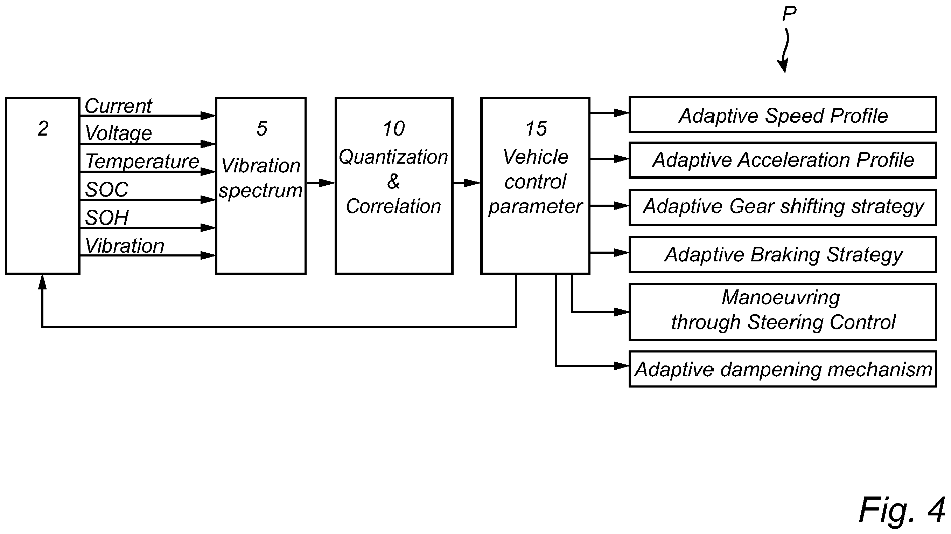

Fig. 4 is a functional box diagram of examples of the present disclosure. Data indicating the status of the electrical energy storage system 2 is collected or estimated from measures of some of the data, such as electrical current, voltage, temperature, SOC, SOH, and the vibration data 5, measured using suitable sensors. The vibration spectrum is analysed so that the vibration-SOH model 10 can perform correlation between SoH and vibration data to infer determine cause-effect relationship. The vibration-SOH model 10 quantifies the impact of the vibrations on ageing to thereby determine the degree of impact on the SOH. This may include filtering out those events from the collected vibration data where vibration is affecting the state of health and to estimate or rank its magnitude in terms of impact as a stress factor.

A vehicle control parameter P is adjusted to reduce the impact of the vibration determined from the vibration data 5 on the aging. Example vehicle control parameters are adaptive speed control, adaptive acceleration control, adaptive gear shifting strategies, adaptive braking, manoeuvring through steering control, and adaptive damping mechanisms.

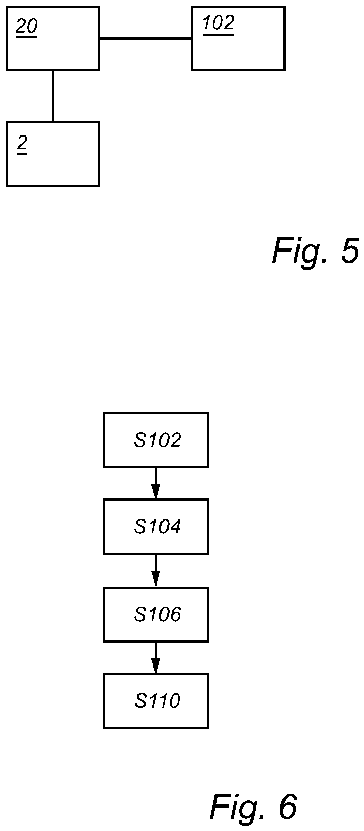

Fig. 5 is a block diagram of a system 100 for improving a lifetime of an electrical energy storage system 2 adapted for providing propulsion power for a vehicle 1, the system 100 comprises a vibration sensor 20 on or near the electrical energy storage system 2. The vibration sensor 20 is configured to acquire vibration data indicative of a vibration magnitude and vibration frequency spectrum of the electrical energy storage system 2. The system 100 further comprises a control unit configure to: estimate a present state of health of the electrical energy storage system 2. Determine vibration data including mechanical vibration magnitude and vibration frequency spectrum of the electrical energy storage system. Determine a degree of impact of the vibrations of the electrical energy storage system on the state of health of the electrical energy storage system by processing the determined vibration magnitude and vibration frequency spectrum in a vibration-SOH model adapted to infer a relationship between vibration magnitude and vibration frequency spectrum, and state of health. Adapting at least one vehicle control parameter to vary at least one of the vibration magnitude and the vibration frequency to reduce the determining a degree of impact of the vibrations of the electrical energy storage system.

There is further provided a computer program product comprising program code for performing, when executed by a processor device, when said program is run on a computer: estimating a present state of health of the electrical energy storage system; determining vibration data including mechanical vibration magnitude and vibration frequency spectrum of the electrical energy storage system; determining a degree of impact of the vibrations of the electrical energy storage system on the state of health of the electrical energy storage system by processing the determined vibration magnitude and vibration frequency spectrum in a vibration-SOH model adapted to infer a relationship between vibration magnitude and vibration frequency spectrum, and state of health, and adapting at least one vehicle control parameter to vary at least one of the vibration magnitude and the vibration frequency to reduce the determining a degree of impact of the vibrations of the electrical energy storage system.

There is further provided a non-transitory computer-readable storage medium comprising instructions, which when executed by the processor device, cause the processor device to: estimate a present state of health of the electrical energy storage system2. Determine vibration data including mechanical vibration magnitude and vibration frequency spectrum of the electrical energy storage system. Determine a degree of impact of the vibrations of the electrical energy storage system on the state of health of the electrical energy storage system by processing the determined vibration magnitude and vibration frequency spectrum in a vibration-SOH model adapted to infer a relationship between vibration magnitude and vibration frequency spectrum, and state of health. Adapting at least one vehicle control parameter to vary at least one of the vibration magnitude and the vibration frequency to reduce the determining a degree of impact of the vibrations of the electrical energy storage system.

FIG. 6 is a flow chart of an exemplary method for improving a lifetime of an electrical energy storage system adapted for providing propulsion power for a vehicle, the method comprising step S102 of estimating a present state of health of the electrical energy storage system.

Step S104 is determining vibration data including mechanical vibration magnitude and vibration frequency spectrum of the electrical energy storage system.

S106 is determining a degree of impact of the vibrations of the electrical energy storage system on the state of health of the electrical energy storage system by processing the determined vibration magnitude and vibration frequency spectrum in a vibration-SOH model adapted to infer a relationship between vibration magnitude and vibration frequency spectrum, and state of health.

Step S106 is adapting at least one vehicle control parameter (P) to vary at least one of the vibration magnitude and the vibration frequency to reduce the determining a degree of impact of the vibrations of the electrical energy storage system.

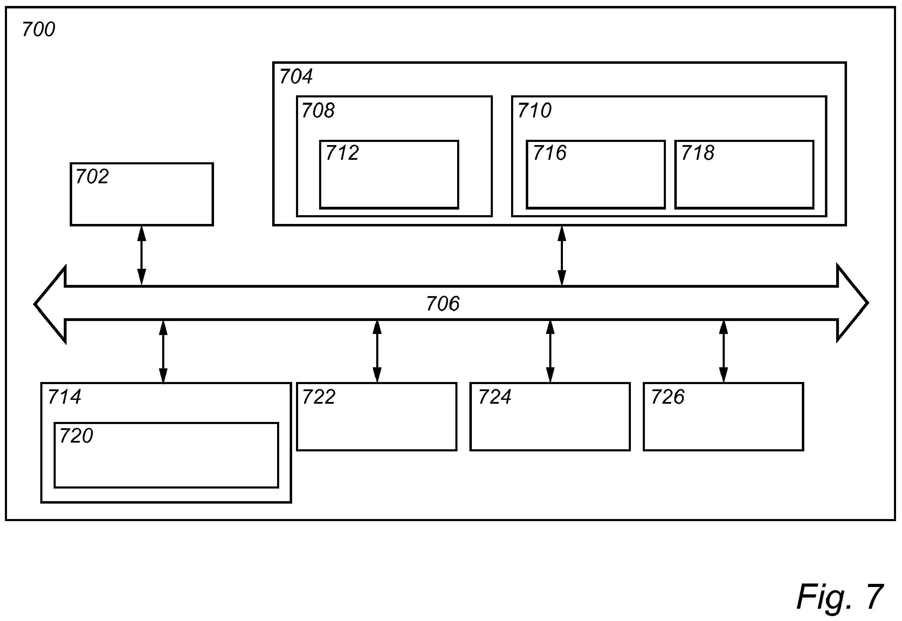

FIG. 7 is a schematic diagram of a computer system 700 for implementing examples disclosed herein. The computer system 700 is adapted to execute instructions from a computer-readable medium to perform these and/or any of the functions or processing described herein. The computer system 700 may be connected (e.g., networked) to other machines in a LAN, an intranet, an extranet, or the Internet. While only a single device is illustrated, the computer system 700 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 700 may comprise at least one computing device or electronic device capable of including firmware, hardware, and/or executing software instructions to implement the functionality described herein. The computer system 700 may include a processor device 702 (may also be referred to as a control unit), a memory 704, and a system bus 706. The computer system 700 may include at least one computing device having the processor device 702. The system bus 706 provides an interface for system components including, but not limited to, the memory 704 and the processor device 702. The processor device 702 may include any number of hardware components for conducting data or signal processing or for executing computer code stored in memory 704. The processor device 702 (e.g., control unit) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device may further include computer executable code that controls operation of the programmable device.

The system bus 706 may be any of several types of bus structures that may further interconnect to a memory bus (with or without a memory controller), a peripheral bus, and/or a local bus using any of a variety of bus architectures. The memory 704 may be one or more devices for storing data and/or computer code for completing or facilitating methods described herein. The memory 704 may include database components, object code components, script components, or other types of information structure for supporting the various activities herein. Any distributed or local memory device may be utilized with the systems and methods of this description. The memory 704 may be communicably connected to the processor device 702 (e.g., via a circuit or any other wired, wireless, or network connection) and may include computer code for executing one or more processes described herein. The memory 704 may include non-volatile memory 708 (e.g., read-only memory (ROM), erasable programmable read-only memory (EPROM), electrically erasable programmable read-only memory (EEPROM), etc.), and volatile memory 710 (e.g., random-access memory (RAM)), or any other medium which can be used to carry or store desired program code in the form of machine-executable instructions or data structures and which can be accessed by a computer or other machine with a processor device 702. A basic input/output system (BIOS) 712 may be stored in the non-volatile memory 708 and can include the basic routines that help to transfer information between elements within the computer system 700.

The computer system 700 may further include or be coupled to a non-transitory computer-readable storage medium such as the storage device 714, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 714 and other drives associated with computer-readable media and computer-usable media may provide non-volatile storage of data, data structures, computer-executable instructions, and the like.

A number of modules can be implemented as software and/or hard-coded in circuitry to implement the functionality described herein in whole or in part. The modules may be stored in the storage device 714 and/or in the volatile memory 710, which may include an operating system 716 and/or one or more program modules 718. All or a portion of the examples disclosed herein may be implemented as a computer program product 720 stored on a transitory or non-transitory computer-usable or computer-readable storage medium (e.g., single medium or multiple media), such as the storage device 714, which includes complex programming instructions (e.g., complex computer-readable program code) to cause the processor device 702 to carry out the steps described herein. Thus, the computer-readable program code can comprise software instructions for implementing the functionality of the examples described herein when executed by the processor device 702. The processor device 702 may serve as a controller or control system for the computer system 700 that is to implement the functionality described herein.

The computer system 700 also may include an input device interface 722 (e.g., input device interface and/or output device interface). The input device interface 722 may be configured to receive input and selections to be communicated to the computer system 700 when executing instructions, such as from a keyboard, mouse, touch-sensitive surface, etc. Such input devices may be connected to the processor device 702 through the input device interface 722 coupled to the system bus 706 but can be connected through other interfaces such as a parallel port, an Institute of Electrical and Electronic Engineers (IEEE) 1394 serial port, a Universal Serial Bus (USB) port, an IR interface, and the like. The computer system 700 may include an output device interface 724 configured to forward output, such as to a display, a video display unit (e.g., a liquid crystal display (LCD) or a cathode ray tube (CRT)). The computer system 700 may also include a communications interface 726 suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A computer implemented-method for improving a lifetime of an electrical energy storage system (2) adapted for providing propulsion power for a vehicle (1), the method comprising:
estimating (S102) a present state of health of the electrical energy storage system;
determining (S104) vibration data (5) including mechanical vibration magnitude and vibration frequency spectrum of the electrical energy storage system;
determining (S106) a degree of impact (S) of the vibrations of the electrical energy storage system on the state of health of the electrical energy storage system by processing the determined vibration magnitude and vibration frequency spectrum in a vibration-SOH model (10) adapted to infer a relationship between vibration magnitude and vibration frequency spectrum, and state of health, and
adapting (S110) at least one vehicle control parameter (P) to vary at least one of the vibration magnitude and the vibration frequency to reduce the degree of impact of the vibrations of the electrical energy storage system.

2. The method according to claim 1, wherein adapting the at least one vehicle control parameter includes employing a vibration model (15) including at least one relationship between the at least one vehicle control parameter and the respective effect on the vibration magnitude and the vibration frequency of the electrical energy storage system.

3. The method according to any one of claims 1 and 2, wherein the at least one vehicle control parameter includes a speed profile, an acceleration profile, a gear-shifting strategy, a braking strategy, and steering control, and a dampening mechanism, of the vehicle.

4. The method according to claim 3, wherein the dampening mechanism is a controllable local dampening mechanism (12) for the electrical energy storage system.

5. The method according to any one of the preceding claims, wherein the step of adapting comprises adapting a combination of at least two vehicle control parameters.

6. The method according to claim 5, wherein one of the at least two vehicle control parameters is a local dampening mechanism for the electrical energy storage system.

7. The method according to any one of the preceding claims, wherein the vehicle control parameters are adapted in such a way that the vehicle can reach an intended destination subject to travelling constraints.

8. The method according to any one of the preceding claims, wherein vibration data are measured using a vibration sensor (20) arranged on or near the electrical energy storage system or on an electrical energy storage cell, and the mechanical vibration magnitude and vibration frequency spectrum are determined from analysing the vibration data.

9. The method according to claim 2, wherein an outcome of the adaption of at least one vehicle control parameter on the state of health of the electrical energy storage system is fed back to update the vibration model.

10. The method according to any one of the preceding claims, wherein the method steps are performed while the vehicle is travelling.

11. A computer program product comprising program code for performing, when executed by a processor device, the method of any of claims 1-10, when said program is run on a computer.

12. A non-transitory computer-readable storage medium comprising instructions, which when executed by the processor device, cause the processor device to perform the method of any of claims 1-10.

13. A control unit (102) for improving a lifetime of an electrical energy storage system adapted for providing propulsion power for a vehicle, the control unit is configured to perform the steps of the method according to any of claims 1-10.

14. A vehicle comprising a control unit according to claim 13.

15. A system (100) for improving a lifetime of an electrical energy storage system adapted for providing propulsion power for a vehicle, the system comprising:
a vibration sensor (20) on or near the electrical energy storage system, the vibration sensor is configured to acquire vibration data indicative of a vibration magnitude and vibration frequency spectrum of the electrical energy storage system; and
a control unit (102) according to claim 13.
